(19) Europäisches Patentamt
European Patent Office
Office européen des brevets

(11) **EP 4 112 588 B1**

(12) **EUROPEAN PATENT SPECIFICATION**

(45) Date of publication and mention
of the grant of the patent:
**17.04.2024 Bulletin 2024/16**

(21) Application number: **21779621.8**

(22) Date of filing: **30.03.2021**

(51) International Patent Classification (IPC):
*C04B 35/583* (2006.01)      *C04B 41/48* (2006.01)
*C04B 41/00* (2006.01)      *C04B 38/00* (2006.01)
*C04B 41/83* (2006.01)      *C04B 35/64* (2006.01)
*C04B 35/626* (2006.01)      *H05K 1/03* (2006.01)
*C04B 111/00* (2006.01)

(52) Cooperative Patent Classification (CPC):
(C-Sets available)
**C04B 41/83; C04B 35/583; C04B 35/64;**
**C04B 38/0074; C04B 41/009; C04B 41/48;**
**C04B 41/4853;** C04B 35/62655; C04B 35/62695;
C04B 2111/00844; C04B 2235/3208;
C04B 2235/3409; C04B 2235/3821;
C04B 2235/3856; C04B 2235/386;      (Cont.)

(86) International application number:
**PCT/JP2021/013655**

(87) International publication number:
**WO 2021/201012 (07.10.2021 Gazette 2021/40)**

(54) **METHOD FOR PRODUCING COMPOSITE BODY**

VERFAHREN ZUR HERSTELLUNG EINES VERBUNDKÖRPERS

PROCÉDÉ SERVANT À PRODUIRE UN CORPS COMPOSITE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **31.03.2020 JP 2020064834**

(43) Date of publication of application:
**04.01.2023 Bulletin 2023/01**

(73) Proprietor: **Denka Company Limited**
**Tokyo 103-8338 (JP)**

(72) Inventors:
• **MINAKATA Yoshitaka**
**Tokyo 103-8338 (JP)**
• **WAKUDA Yusuke**
**Tokyo 103-8338 (JP)**
• **SAKAGUCHI Shinya**
**Tokyo 103-8338 (JP)**
• **YAMAGUCHI Tomoya**
**Tokyo 103-8338 (JP)**
• **NISHIMURA Koji**
**Tokyo 103-8338 (JP)**

(74) Representative: **Hoffmann Eitle**
**Patent- und Rechtsanwälte PartmbB**
**Arabellastraße 30**
**81925 München (DE)**

(56) References cited:
**WO-A1-2018/066277      WO-A1-2019/073690**
**WO-A1-2020/004600      JP-A- H05 159 624**
**JP-A- 2019 073 409**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 112 588 B1

(52) Cooperative Patent Classification (CPC): (Cont.)
C04B 2235/3895; C04B 2235/5436;
C04B 2235/604; C04B 2235/6586; C04B 2235/77;
C04B 2235/787; C04B 2235/94; C04B 2235/95;
C04B 2235/9607; H05K 1/03

C-Sets
**C04B 38/0074, C04B 35/583, C04B 38/0054;**
**C04B 41/009, C04B 35/583, C04B 38/00**

## Description

### Technical Field

The present disclosure relates to a method for manufacturing a composite body.

### Background Art

In components such as a power device, a transistor, a thyristor, and a CPU, efficient dissipation of heat generated during use thereof is required. From such a request, conventionally, a thermal conductivity of an insulating layer of a printed-wiring board onto which an electronic component is to be mounted has been improved, or an electronic component or a printed-wiring board has been mounted onto a heat sink via thermal interface materials having electrical insulation properties. A composite body (heat dissipation member) configured by a resin and ceramic such as boron nitride is used for the insulating layer and the thermal interface material described above.

It has been studied to use a composite body obtained by impregnating a porous ceramic molded body with a resin as such a composite body. Boron nitride has lubricity, high thermal conducting properties, insulation properties, and the like, and from this aspect, it has been studied to use ceramic containing boron nitride for a heat dissipation member. Patent Literature 1 has proposed a technique of adjusting an orientation degree and a graphitization index in predetermined ranges to decrease the anisotropy of the thermal conductivity while attaining an excellent thermal conductivity.

Patent Literature 2 has proposed a method for preparing a boron nitride powder excellent in heat conductivity and fillability by adjusting the particle strength and orientation index of a mixture of fine and coarse boron nitride powders within a specific ratio range.

Patent Literature 3 has proposed a method for preparing a bulk boron nitride powder having excellent insulating properties and thermal conductivity by adjusting the particle strength and area ratio of boron nitride particles.

Patent Literature 4 has proposed a method for preparing a boron nitride powder by adjusting the particle strength, average particle diameter and orientation index of boron nitride particles.

Patent Literature 5 has proposed the use of a boron nitride powder comprising boron nitride particles of specific dimensions, size and particle strength.

Patent Literature 6 has proposed the use of an insulating radiator plate comprising boron nitride and impregnated with heat radiating oil.

### Citation List

### Patent Literature

Patent Literature 1: Japanese Unexamined Patent Publication No. 2014-162697
Patent Literature 2: JP 2019/073409 A
Patent Literature 3: WO 2020/004600 A1
Patent Literature 4: WO 2019/073690 A1
Patent Literature 5: WO 2018/066277 A1
Patent Literature 6: JP H05-159624 A

### Summary of Invention

### Technical Problem

With an increase in integration density of a circuit inside an electronic component in recent years, a composite body having excellent insulation properties has been demanded. In this regard, the present disclosure provides a manufacturing method by which a composite body having excellent insulation properties can be manufactured.

### Solution to Problem

According to an aspect of the present disclosure, there is provided a method for manufacturing a composite body, the method including: a sintering step of molding and heating a blend containing a boron carbonitride powder and a sintering aid to obtain a boron nitride sintered body including boron nitride particles and pores; and an impregnating step of impregnating the boron nitride sintered body with a resin composition, the composite body having the boron nitride sintered body and a resin filled in at least some of the pores of the boron nitride sintered body.

In this manufacturing method, a boron nitride sintered body is obtained by molding and heating a blend containing boron carbonitride and a sintering aid. The pore diameter of the pores included in this boron nitride sintered body is sufficiently small. In the impregnating step, the pores can be sufficiently impregnated with the resin composition by capillarity accordingly. Therefore a composite body in which voids are sufficiently reduced can be manufactured. Since such a composite body has excellent electrical insulation properties, the composite body is useful, for example, as a heat dissipation member of an electronic component. However, the use application thereof is not limited to a heat dissipation member.

According to an aspect of the present disclosure, there is provided a method for manufacturing a composite body, the method including: a nitriding step of firing a boron carbide powder in a nitrogen atmosphere to obtain a fired product containing boron carbonitride; a sintering step of molding and heating a blend containing the fired product and a sintering aid to obtain a boron nitride sintered body including boron nitride particles and pores; and an impregnating step of impregnating the boron nitride sintered body with a resin composition, the composite body including the boron nitride sintered body and a resin filled in at least some of the pores of the boron nitride sintered body.

In this manufacturing method, a boron nitride sintered body is obtained by molding and heating the blend containing the fired product containing boron carbonitride and the sintering aid. The pore diameter of the pores included in this boron nitride sintered body is sufficiently small. In the impregnating step, the pores can be sufficiently impregnated with the resin composition by capillarity accordingly. Therefore a composite body in which voids are sufficiently reduced can be manufactured. Since such a composite body has excellent electrical insulation properties, the composite body is useful, for example, as a heat dissipation member of an electronic component. However, the use application thereof is not limited to a heat dissipation member.

A porosity of the boron nitride sintered body obtained in the sintering step may be 30 to 65% by volume. Thereby, a balance between the mass and the strength of the composite body can be suitably maintained.

The boron nitride sintered body obtained in the sintering step may have a thickness of 2 mm or more, and the method may include a cutting step of cutting the boron nitride sintered body to obtain the boron nitride sintered body having a sheet shape with a thickness of less than 2 mm, between the sintering step and the impregnating step. By processing the boron nitride sintered body into a sheet shape in this way, a composite body having a high filling rate of the resin can be obtained. Such a composite body is further excellent in electrical insulation properties.

A thickness of the boron nitride sintered body obtained in the sintering step may be less than 2 mm, and in the impregnating step, the boron nitride sintered body obtained in the sintering step may be impregnated with the resin composition without cutting the boron nitride sintered body. Thereby, generation of chips generated attributable to cutting is suppressed, so that the yield of the composite body can be increased.

The method may include a curing step of curing the resin filled in the pores of the boron nitride sintered body after the impregnating step.

**Advantageous Effects of Invention**

According to the present disclosure, it is possible to provide a method for manufacturing a composite body by which a composite body having excellent electrical insulation properties can be manufactured.

**Brief Description of Drawings**

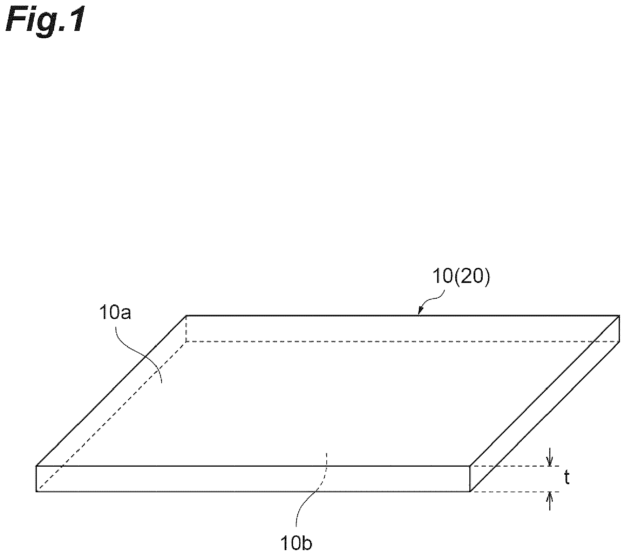

FIG. 1 is a perspective view illustrating an example of a composite body and a boron nitride sintered body.

**Description of Embodiments**

Hereinafter, embodiments of the present disclosure will be described. However, the following embodiments are examples for describing the present disclosure and are not intended to limit the present disclosure to the following contents.

<First embodiment of method for manufacturing composite body>

A first embodiment of a method for manufacturing a composite body will be described below. The manufacturing method of the present embodiment includes a nitriding step of firing a boron carbide powder in a nitrogen pressurized atmosphere to obtain a fired product containing boron carbonitride, a sintering step of molding and heating a blend containing the fired product and a sintering aid to obtain a boron nitride sintered body including boron nitride particles and pores, and an impregnating step of impregnating the boron nitride sintered body with a resin composition.

The boron carbide powder can be prepared, for example, by the following procedures. Boric acid and acetylene black are mixed and then heated in an inert gas atmosphere at 1800 to 2400°C for 1 to 10 hours to obtain a boron carbide lump. The boron carbide powder can be prepared by subjecting this boron carbide lump to pulverization, washing, impurity removal, and drying.

In the nitriding step, a boron carbide powder is fired in a nitrogen atmosphere to obtain a fired product containing boron carbonitride ($B_4CN_4$). The firing temperature in the nitriding step may be 1800°C or higher or may be 1900°C or higher. Furthermore, this firing temperature may be 2400°C or lower or may be 2200°C or lower. This firing temperature may be, for example, 1800 to 2400°C.

The pressure in the nitriding step may be 0.6 MPa or more or may be 0.7 MPa or more. Furthermore, this pressure may be 1.0 MPa or less or may be 0.9 MPa or less. This pressure may be, for example, 0.6 to 1.0 MPa. When the pressure is too low, there is a tendency that the nitriding of boron carbide is difficult to proceed. On the other hand, when this pressure is too high, there is a tendency that manufacturing cost is increased. Note that, the pressure in the present disclosure is an absolute pressure.

The nitrogen gas concentration of the nitrogen atmosphere in the nitriding step may be 95% by volume or more or may be 99.9% by volume or more. The partial pressure of nitrogen may be in the above pressure range. The firing time in the nitriding step is not particularly limited as long as it is in a range in which the nitriding sufficiently proceeds, and for example, may be 6 to 30 hours or may be 8 to 20 hours.

In the sintering step, a blend may be obtained by blending the fired product containing boron carbonitride particles obtained in the nitriding step and the sintering aid. The sintering aid may contain a boron compound and a calcium compound. The blend may contain 1 to 30 parts by mass of the boron compound and the calcium compound in total with respect to 100 parts by mass of the fired product. When the content is set in such a range, the grain growth is appropriately performed while suppressing excessive grain growth of primary particles to promote the sintering, and the primary particles of boron nitride are bonded firmly and intimately over the broad area.

From the viewpoint of sufficiently bonding the primary particles of boron nitride, the blend may contain, for example, 2 to 30 parts by mass, 5 to 25 parts by mass, or 8 to 20 parts by mass of the boron compound and the calcium compound in total, with respect to 100 parts by mass of the fired product.

The blend may contain 0.5 to 40 atom% or 0.7 to 30 atom% of calcium constituting the calcium compound with respect to 100 atom% of boron constituting the boron compound. When the blend contains boron and calcium in such a ratio, homogeneous grain growth of primary particles is promoted, and the thermal conductivity of the boron nitride sintered body can be further increased.

Examples of the boron compound include boric acid, boron oxide, borax, and the like. Examples of the calcium compound include calcium carbonate, calcium oxide, and the like. The sintering aid may contain a component other than boric acid and calcium carbonate. Examples of such a component include carbonates of alkali metals such as lithium carbonate and sodium carbonate. Furthermore, for moldability improvement, a binder may be blended in the blend. Examples of the binder include an acrylic compound and the like.

The pulverization of the fired product may be performed using a general pulverizer or disintegrator when the fired product and the sintering aid are blended. For example, a ball mill, a Henschel mixer, a vibrating mill, a jet mill, or the like can be used. Note that, in the present disclosure, "disintegration" is also included in "pulverization". The fired product may be pulverized and then blended with the sintering aid, or the fired product and the sintering aid may be blended and then subjected to pulverization and mixing at the same time.

The blend may be subjected to powder pressing or die molding to obtain a block-shaped molded body, or may be formed into a sheet-shaped molded body by a doctor blade method. The molding pressure may be, for example, 5 to 350 MPa. It is preferable that the shape of the molded body is, for example, a sheet shape having a thickness of 2 mm or less. When a boron nitride sintered body is manufactured using such a sheet-shaped molded body, a composite body can be manufactured without cutting the boron nitride sintered body and the composite body. Furthermore, as compared to a case where a block-shaped boron nitride sintered body and a block-shaped composite body are cut into a sheet shape, material loss caused by processing can be reduced in the case of using a molded body which has been formed in a sheet shape. Hence, a sheet-shaped composite body can be manufactured at a high yield.

The molded body obtained as described above is fired, for example, heating in an electric furnace. The heating temperature may be, for example, 1800°C or higher or may be 1900°C or higher. This heating temperature may be, for example, 2200°C or lower or may be 2100°C or lower. When the heating temperature is too low, there is a tendency that the grain growth does not sufficiently proceed. The heating time may be 0.5 hours or longer, may be 1 hour or longer, may be 3 hours or longer, may be 5 hours or longer, or may be 10 hours or longer. This heating time may be 40 hours or shorter, may be 30 hours or shorter, or may be 20 hours or shorter. This heating time may be, for example, 0.5 to 40 hours or may be 1 to 30 hours. When the heating time is too short, there is a tendency that the grain growth does not sufficiently proceed. On the other hand, a too long heating time tends to be disadvantageous in terms of industrial aspect. The heating atmosphere may be, for example, an inert gas atmosphere such as nitrogen, helium, or argon. In the case of blending a binder in the blend, degreasing may be performed by calcining at a temperature and an atmosphere where the binder is decomposed, before the above-described heating.

Through the above steps, a boron nitride sintered body including boron nitride particles and pores can be obtained. When a thin sheet-shaped molded body is used, a sheet-shaped boron nitride sintered body can be obtained. In this example, since the fired product containing boron carbonitride is used, orientation of the boron nitride particles in a direction perpendicular to the thickness direction can be suppressed. Hence, the anisotropy of the thermal conducting properties is decreased, and thus a boron nitride sintered body excellent in thermal conducting properties along the thickness direction can be manufactured. Furthermore, the pore diameter of the pores included in the boron nitride sintered body can be decreased as a whole. The range of the orientation index of the boron nitride sintered body is as described above.

Note that, a boron carbonitride powder may be used instead of the fired product containing boron carbonitride. For example, the boron carbonitride powder having an average particle diameter of 15 to 50 μm can be used. The boron nitride sintered body may be obtained by blending the boron carbonitride powder and the above-described sintering aid and performing the above-described sintering step.

In the impregnating step, the boron nitride sintered body is impregnated with the resin composition. In a case where the boron nitride sintered body obtained in the sintering step has a sheet shape, the boron nitride sintered body can be directly used without processing the boron nitride sintered body. The thickness of the boron nitride sintered body may be 2 mm or less, may be less than 2 mm, or may be 1 mm or less. On the other hand, in a case where the boron nitride sintered body obtained in the sintering step has a block shape, a cutting step of processing the block-shaped boron nitride sintered body into a sheet shape is performed. The block-shaped boron nitride sintered body may be subjected to cut processing into a sheet shape, for example, having a thickness of 2 mm or less in the cutting step, and then may be impregnated with the resin composition. The thickness of the boron nitride sintered body after cutting may be less than 2 mm or may be 1 mm or less. Note that, when the block-shaped boron nitride sintered body is, for example, a polyhedron, all of sides have a proportionate length, and the block-shaped boron nitride sintered body has a larger thickness than the sheet-shaped boron nitride sintered body. That is, the block shape refers to a shape which can be divided into a plurality of sheet shapes (thin plate shapes) by cutting.

The resin composition may have a thermosetting property and may contain, for example, at least one compound selected from the group consisting of a compound having a cyanate group, a compound having a bismaleimide group, and a compound having an epoxy group, at least one curing agent selected from the group consisting of a phosphine-based curing agent and an imidazole-based curing agent, and a solvent.

Examples of the solvent include aliphatic alcohols such as ethanol and isopropanol, ether alcohols such as 2-methoxy ethanol, 1-methoxy ethanol, 2-ethoxy ethanol, 1-ethoxy-2-propanol, 2-butoxyethanol, 2-(2-methoxyethoxy)ethanol, 2-(2-ethoxyethoxy)ethanol, and 2-(2-butoxyethoxy)ethanol, glycol ethers such as ethylene glycol monomethyl ether and ethylene glycol monobutyl ether, ketones such as acetone, methyl ethyl ketone, methyl isobutyl ketone, and diisobutyl ketone, and hydrocarbons such as toluene and xylene. These may be included singly or in combination of two or more kinds thereof.

The component of the resin composition is not limited to the above-described components, and for example, those which become a resin by a curing or semi-curing reaction can be used. Examples of the resin include an epoxy resin, a silicone resin, a cyanate resin, a silicone rubber, an acrylic resin, a phenolic resin, a melamine resin, a urea resin, a bismaleimide resin, unsaturated polyester, a fluorine resin, polyimide, polyamide imide, polyether imide, polybutylene terephthalate, polyethylene terephthalate, polyphenylene ether, polyphenylene sulfide, wholly aromatic polyester, polysulfone, a liquid crystal polymer, polyether sulfone, polycarbonate, a maleimide resin, a maleimide-modified resin, an ABS (acrylonitrile-butadiene-styrene) resin, an AAS (acrylonitrile-acrylic rubber-styrene) resin, an AES (acrylonitrile-ethylene-propylene-diene rubber-styrene) resin, a polyglycolic acid resin, polyphthalamide, polyacetal, and the like. These may be included singly or in combination of two or more kinds thereof.

From the viewpoint of improving fluidity and handleability, the resin composition may contain an inorganic filler, a silane coupling agent, a defoamer, a surface conditioner, a wetting and dispersing agent, and the like.

The impregnating is performed by attaching the resin composition to the boron nitride sintered body. The impregnating method is not particularly limited, but since the boron nitride sintered body has a sufficiently small pore diameter, the resin composition is easily impregnated by capillarity. The impregnating step can be performed by using a resin composition having a high viscosity and applying the resin composition to the boron nitride sintered body accordingly. In the application, for example, dipping coating, screen printing, transfer printing, offset printing, a bar coater, an air dispenser, a comma coater, a gravure coater, anastatic printing, intaglio printing, gravure printing, stencil printing, soft lithography, bar coating, an applicator, a spin coater, a dip coater, a rubber spatula, a brush, and the like can be used.

Since the pore diameter of the pores in the boron nitride sintered body is small as a whole, the resin composition is easily impregnated by capillarity. Further, when the boron nitride sintered body has a sheet shape having a thickness of 2 mm or less, the resin composition can be sufficiently impregnated into the inside. In a case where a boron nitride sintered body having a sheet shape with a thickness of 2 mm or less is impregnated with the resin composition by application, the viscosity of the resin composition may be 5000 m.Pa·s or less or may be 2000 mPa·s or less. Even in the case of a resin composition having such a high viscosity, when the boron nitride sintered body has the above-described thickness, the resin composition can be sufficiently impregnated by utilizing capillarity. From the viewpoint of sufficiently reducing voids of the composite body, the viscosity of the resin composition may be 1 mPa·s or more or may be 5 mPa·s or more. The amount of the resin composition applied to the boron nitride sintered body may be 1 to 1.5 times on the basis of the total pore volume of the boron nitride sintered body.

In this way, a composite body having the boron nitride sintered body and a resin filled in the pores thereof is obtained. It is not necessary to fill the resin in all of the pores of the boron nitride sintered body, and the resin may not be filled in some of the pores. The boron nitride sintered body and the composite body may include both of closed pores and open pores.

The method may include a curing step of curing the resin filled in the pores after the impregnating step. In the curing step, for example, the composite body filled with the resin (resin composition) is extracted from an impregnating apparatus, and then the resin is cured or semi-cured by heating and/or light irradiation depending on the type of the resin (or a curing agent to be added as necessary).

The composite body obtained in this way has, for example, a sheet shape and a thin thickness. Thus, the composite body is thin and lightweight, and when the composite body is used as a member of an electronic component and the like, a decrease in size and weight of an electronic component and the like can be achieved. Furthermore, since the resin is sufficiently filled in the pores of the boron nitride sintered body, the composite body is also excellent in electrical insulation properties. Furthermore, in the above-described manufacturing method, the composite body can be manufactured without the method including a step of cutting a boron nitride sintered body and a composite body. Hence, the composite body excellent in reliability can be manufactured at a high yield. Note that, the composite body may be used directly as a heat dissipation member, or may be subjected to processing such as polishing and used as a heat dissipation member.

A composite body obtained through the cutting step has fine cracks or fine irregularities (striped patterns) generated attributable to cutting on the cut plane. On the other hand, a composite body obtained without performing the cutting step does not have a cut plane, and thus fine cracks and irregularities (striped patterns) on the surface can be sufficiently reduced. In the composite body obtained without performing the cutting step, the electrical insulation properties and the thermal conducting properties can be sufficiently improved while maintaining a sufficiently high strength accordingly. That is, reliability as a member of an electronic component and the like is excellent. Furthermore, when processing such as cutting is performed, material loss occurs. Hence, in the composite body not having a cut plane, material loss can be reduced. Thereby, the yield of the boron nitride sintered body can be improved.

<Second embodiment of method for manufacturing composite body>

A method for manufacturing a composite body of the present embodiment includes a nitriding step of firing a boron carbide powder in a nitrogen pressurized atmosphere to obtain a fired product containing boron carbonitride, a sintering step of molding and heating a blend containing the fired product and a sintering aid to obtain a boron nitride sintered body including boron nitride particles and pores, an impregnating step of impregnating the boron nitride sintered body with a resin composition, and a cutting step of cutting a resin-impregnated body to obtain the composite body.

The nitriding step and the sintering step can be performed in the same manner as in the first embodiment described above. However, in the present embodiment, not only a sheet-shaped boron nitride sintered body but also a block-shaped boron nitride sintered body can be used. However, the block-shaped boron nitride sintered body is more difficult to be impregnated with the resin composition than the sheet-shaped boron nitride sintered body. It is therefore preferable that the boron nitride sintered body is immersed in the resin composition and then the impregnating step is performed in the immersed state under a pressurized or depressurized condition.

The impregnating step may be performed using the inside of an impregnating apparatus including an airtight container. As an example, the impregnating may be performed inside the impregnating apparatus under a depressurized condition, and then the impregnating may be performed under a pressurized condition by increasing the pressure inside the impregnating apparatus to be higher than the atmospheric pressure. By performing both the depressurized condition and the pressurized condition in this way, the resin can be sufficiently filled in the pores of the boron nitride sintered body. The depressurized condition and the pressurized condition may be repeated multiple times.

The pressure in the impregnating apparatus in the case of executing the impregnating step under a depressurized condition may be, for example, 1000 Pa or less, 500 Pa or less, 100 Pa or less, 50 Pa or less, or 20 Pa or less. The pressure in the impregnating apparatus in the case of executing the impregnating step under a pressurized condition may be, for example, 1 MPa or more, 3 MPa or more, 10 MPa or more, or 30 MPa or more.

In the impregnating step, a solution containing the resin composition may be heated. By heating the solution in the following temperature range, the viscosity of the solution is adjusted so that the impregnating of the resin composition can be promoted. The viscosity of the solution containing the resin composition at the time of impregnating of the resin composition is preferably 1000 mPa·s or less and more preferably 500 mPa·s or less, from the viewpoint of sufficiently impregnating the pores with the resin composition. As described above, it is necessary to decrease the viscosity of the resin composition as compared to the case of impregnating the sheet-shaped boron nitride sintered body with the resin composition. By using the solution having such a viscosity, the boron nitride sintered body can be sufficiently impregnated with the resin composition. The viscosity of the resin composition may be 1 mPa·s or more or may be 5 mPa·s or more. The component of the resin composition is the same as in the first embodiment.

In the impregnating step, a nitride sintered body is held for a predetermined time in a state of the nitride sintered body being immersed in the solution containing the resin composition. The predetermined time may be, for example, 5 hours or longer or may be 10 hours or longer. The impregnating step may be performed while heating. The resin composition impregnated in the pores of the boron nitride sintered body becomes a resin (a cured product or a semi-cured product) after curing or semi-curing proceeds or the solvent volatilizes.

The method may include a curing step of curing the resin filled in the pores after the impregnating step. In the curing step, for example, the composite body filled with the resin is extracted from the impregnating apparatus, and then the resin is cured or semi-cured by heating and/or light irradiation depending on the type of the resin (or a curing agent to be added as necessary).

In the cutting step, the obtained resin-impregnated body is cut, for example, using a wire saw. The wire saw may be, for example, a multi-wire saw or the like. A composite body having a sheet shape, for example, with a thickness of 2 mm or less can be obtained by such a cutting step. The composite body obtained in this way has a cut plane.

<Composite body>

The composite body obtained by the above-described manufacturing method has a porous boron nitride sintered body composed of boron nitride particles and a resin filled in at least some of pores of the boron nitride sintered body. The composite body may have a sheet shape (thin plate shape). The thickness of the composite body may be, for example, less than 2 mm. The boron nitride particles constituting the boron nitride sintered body are configured by primary particles of boron nitride being sintered (note that, sintering of primary particles also includes sintering of primary particles in secondary particles). In the composite body, the resin is filled in gaps of such boron nitride particles. Since the composite body contains the boron nitride sintered body and the resin, the composite body is excellent in electrical insulation properties and thermal conducting properties.

Since the composite body having a thickness of less than 2 mm is thin, when the composite body is used as a member of an electronic component and the like, an electronic component and the like can be decreased in size. Furthermore, since the composite body is thin and also contains the resin, a decrease in weight can be achieved.

From the viewpoint of further decreasing a size and a weight, the thickness of the composite body may be less than 1 mm, or may be less than 0.5 mm. From the viewpoint of ease of producing a molded body and a sintered body, the thickness of the composite body may be 0.1 mm or more, or may be 0.2 mm or more.

FIG. 1 is a perspective view illustrating an example of a sheet-shaped composite body. A composite body 10 has a thickness t. The thickness t is less than 2 mm. The composite body 10 may include a boron nitride sintered body 20 uniaxially pressurized along the thickness direction and sintered. The area of a main surface 10a of the composite body may be 25 mm$^2$ or more, may be 100 mm$^2$ or more, may be 800 mm$^2$ or more, or may be 1000 mm$^2$ or more.

Since the thickness t of the composite body 10 is small, the impregnating of the resin composition can be smoothly performed. Furthermore, since the composite body 10 is manufactured using a boron nitride sintered body having a sufficiently small pore diameter, the resin is sufficiently filled in the pores (fine pores). Voids are sufficiently reduced, and excellent electrical insulation properties are attained accordingly.

The shape of the composite body 10 is not limited to a quadrilateral prism shape as illustrated in FIG. 1, and for example, may be a columnar shape or may be a C shape in which the main surface 10a is curved. The composite body 10 and the boron nitride sintered body 20 may not have a cut plane. For example, the composite body may be obtained by sintering a molded body having a sheet shape as illustrated in FIG. 1 and then impregnating the molded body with the resin composition.

It is sufficient that both of a pair of main surfaces 10a and 10b of the composite body 10 of FIG. 1 are not cut planes. That is, a side surface of the composite body 10 may be a cut plane. Also in this case, fine cracks, which may be generated attributable to cutting in both of the pair of main surfaces 10a and 10b, can be sufficiently reduced. Sufficiently high thermal conducting properties can be maintained accordingly. Furthermore, material loss can be reduced as compared to a case where both of the pair of main surfaces 10a and 10b are cut planes. Note that, the shape of the surface of the composite body 10 may be adjusted by polishing or the like.

The orientation index of boron nitride crystals in the boron nitride sintered body 20 included in the composite body 10 may be 40 or less, may be 30 or less, may be 15 or less, or may be 10 or less. Thereby, the anisotropy of the thermal conducting properties can be sufficiently decreased. Hence, the thermal conductivity of the sheet-shaped boron nitride sintered body in the thickness direction can be sufficiently increased.

The orientation index of the boron nitride sintered body 20 may be 2.0 or more, may be 3.0 or more, or may be 4.0 or more. The orientation index in the present disclosure is an index for quantifying the orientation degree of boron nitride crystals. The orientation index can be calculated by a peak intensity ratio [I(002)/I(100)] of (002) plane to (100) plane of boron nitride as measured by an X-ray diffractometer.

The average pore diameter of pores in the boron nitride sintered body 20 may be less than 4.0 $\mu$m. By decreasing the size of the pores, the filling rate of the resin can be increased. The electrical insulation properties of the composite body 10 can be further enhanced accordingly. From the viewpoint of smoothly performing the impregnating of the boron nitride sintered body 20 with the resin composition, the average pore diameter of the pores may be 0.5 to 3.5 $\mu$m or may be 1.0 to 3.0 $\mu$m. When the average pore diameter becomes excessively large, there is a tendency that the penetration of the resin composition by capillarity is difficult to proceed. On the other hand, when the average pore diameter becomes excessively small, there are tendencies that the porosity of the boron nitride sintered body is decreased, and the impregnation rate of the resin composition is decreased.

The average pore diameter of the pores is determined using a mercury porosimeter on the basis of pore size distribution obtained when pressurization is performed while increasing a pressure from 0.0042 MPa to 206.8 MPa. When the horizontal axis is designated as the pore diameter and the vertical axis is designated as the cumulative pore volume, a pore diameter at which the cumulative pore volume reaches 50% of the total pore volume is an average pore diameter. As the mercury porosimeter, a mercury porosimeter manufactured by SHIMADZU CORPORATION can be used.

The porosity of the boron nitride sintered body 20, that is, the volumetric ratio of the pores in the boron nitride sintered body 20 may be 30 to 65% by volume, may be 30 to 60% by volume, or may be 35 to 55% by volume. When the porosity is too large, the strength of the composite body 10 tends to decrease. On the other hand, when the porosity is too small, the mass tends to increase.

A bulk density [B (kg/m$^3$)] is calculated from the volume and mass of the boron nitride sintered body 20, and then the porosity can be determined by Formula (1) below from this bulk density and the theoretical density [2280 (kg/m$^3$)] of boron nitride.

$$\text{Porosity (\% by volume)} = [1 - (\text{B}/2280)] \times 100 \qquad (1)$$

The bulk density B may be 800 to 1500 kg/m$^3$, may be 850 to 1400 kg/m$^3$, or may be 900 to 1300 kg/m$^3$. When the bulk density B is too large, the mass of the boron nitride sintered body tends to increase. Furthermore, there is a tendency that the filling amount of the resin is decreased to degrade electrical insulation properties of the composite body. On the other hand, when the bulk density B is too small, the strength of the boron nitride sintered body tends to decrease.

The thermal conductivity of the boron nitride sintered body 20 in the thickness direction may be 20 W/(m·K) or more, may be 30 W/(m·K) or more, may be 35 W/(m·K) or more, or may be 40 W/(m·K) or more. When a boron nitride sintered body having a high thermal conductivity is used, a heat dissipation member sufficiently excellent in heat dissipation performance can be obtained. The thermal conductivity (H) can be determined by Calculation Formula (2) below.

$$\text{H} = \text{A} \times \text{B} \times \text{C} \qquad (2)$$

In Formula (2), H represents a thermal conductivity (W/(m·K)), A represents a thermal diffusivity (m$^2$/sec), B represents a bulk density (kg/m$^3$), and C represents a specific heat capacity (J/(kg·K)). The thermal diffusivity A can be measured by a laser flash method. The bulk density B can be determined from the volume and mass of the boron nitride sintered body 20. The specific heat capacity C can be measured using a differential scanning calorimeter. The boron nitride sintered body may have the above-described thermal conductivity in the thickness direction.

A composite body according to an embodiment is a composite body of a boron nitride sintered body and a resin and has the above-described boron nitride sintered body and the resin filled in at least some of the pores of the boron nitride sintered body. Examples of the resin are as described above.

In the case of using the composite body 10 for an insulating layer of a printed-wiring board, from the viewpoint of improving heat resistance and adhesion strength to a circuit, the resin may include an epoxy resin. In the case of using the composite body for a thermal interface material, from the viewpoint of improving heat resistance, flexibility, and adhesion to a heat sink or the like, the resin may include a silicone resin. The resin may be a cured product (in a C-stage state), or may be a semi-cured product (in a B-stage state). Whether or not the resin is in a semi-cured state can be checked, for example, by a differential scanning calorimeter.

The content of the boron nitride particles in the composite body 10 may be 40 to 70% by volume or may be 45 to 65% by volume, on the basis of the total volume of the composite body 10. The content of the resin in the composite body may be 30 to 60% by volume or may be 35 to 55% by volume, on the basis of the total volume of the composite body 10. In the composite body including the boron nitride particles and the resin in such ratios, both of high electrical insulation properties and a high thermal conductivity can be achieved at a high level.

The content of the resin in the composite body 10 may be 10 to 60% by mass, may be 15 to 60% by mass, may be 15 to 50% by mass, may be 20 to 50% by mass, may be 25 to 50% by mass, or may be 25 to 40% by mass, on the basis of the total mass of the composite body. In the composite body including the resin in such a ratio, both of high insulation properties and a high thermal conductivity can be achieved at a high level. The content of the resin in the composite body 10 can be determined by heating the composite body 10 to decompose and remove the resin and calculating the mass of the resin from a difference in mass before and after heating.

The composite body 10 may further include other components in addition to the boron nitride sintered body and the resin filled in the pores thereof. Examples of the other components include a curing agent, an inorganic filler, a silane coupling agent, a defoamer, a surface conditioner, a wetting and dispersing agent, and the like. The inorganic filler may include one or two or more kinds selected from the group consisting of aluminum oxide, silicon oxide, zinc oxide, silicon nitride, aluminum nitride, and aluminum hydroxide. Thereby, the thermal conducting properties of the composite body can be further improved.

The composite body 10 of the present embodiment includes the above-described boron nitride sintered body and the resin filled in the pores thereof, and from this aspect, has both an excellent thermal conductivity and excellent electrical insulation properties. Furthermore, since the composite body is thin and lightweight, when the composite body is used as a member of an electronic component and the like, a decrease in size and weight of an electronic component and the like can be achieved. The composite body has such properties, and from this aspect, can be suitably used as a heat dissipation member. The heat dissipation member may be configured by the above-described composite body, or may be configured by combining another member (for example, a metal plate such as aluminum) and the composite body.

Hereinbefore, several embodiments have been described, but the present disclosure is not intended to be limited to the above-described embodiments at all. For example, in the sintering step, a boron nitride sintered body may be obtained using a hot press in which molding and sintering are simultaneously performed.

## Examples

The contents of the present disclosure will be more specifically described with reference to Examples; however, the present disclosure is not limited to the following Examples.

[Boron nitride sintered body]

(Example 1)

<Production of boron nitride sintered body>

100 parts by mass of orthoboric acid manufactured by Nippon Denko Co., Ltd. and 35 parts by mass of acetylene black (trade name: HS100) manufactured by Denka Company Limited were mixed using a Henschel mixer. The obtained mixture was filled in a graphite crucible. This crucible was heated using an arc furnace in an argon atmosphere at 2200°C for 5 hours to obtain lump boron carbide ($B_4C$). The obtained lump product was coarsely pulverized with a jaw crusher to obtain a coarse powder. This coarse powder was further pulverized with a ball mill having silicon carbide beads ($\phi$10 mm) to obtain a pulverized powder. The carbon amount of the obtained boron carbide powder was 19.9% by mass. The carbon amount was measured with a carbon/sulfur simultaneous analyzer.

The prepared boron carbide powder was filled in a boron nitride crucible. Thereafter, the crucible was heated for 10 hours using a resistance heating furnace in a nitrogen gas atmosphere under the conditions of 2000°C and 0.85 MPa. In this way, a fired product containing boron carbonitride ($B_4CN_4$) was obtained.

Powdery boric acid and calcium carbonate were blended to prepare a sintering aid. Upon the preparation, 1.9 parts by mass of calcium carbonate was blended with respect to 100 parts by mass of boric acid. Regarding the atomic ratio of boron and calcium at this time, the atomic ratio of calcium was 1.2 atom% with respect to 100 atom% of boron. 16 parts by mass of the sintering aid was blended with respect to 100 parts by mass of the fired product and mixed using a Henschel mixer to obtain a powdery blend.

97.4 g of the blend was pressurized using a powder pressing machine at 150 MPa for 30 seconds to obtain a molded body having a block shape (length $\times$ width $\times$ thickness = 49 mm $\times$ 25 mm $\times$ 57 mm). The molded body was put in a boron nitride container and introduced into a batch-type high-frequency furnace. In the batch-type high-frequency furnace, heating was performed for 5 hours under the conditions of normal pressure, a nitrogen flow rate of 5 L/min, and 2000°C. Thereafter, a boron nitride sintered body was extracted from the boron nitride container. In this way, a block-shaped boron nitride sintered body was obtained. The thickness t of the boron nitride sintered body was 60 mm.

<Measurement of thermal conductivity>

The thermal conductivity (H) of the boron nitride sintered body in the thickness direction was determined by Calculation Formula (3) below.

$$H = A \times B \times C \qquad (3)$$

In Formula (3), H represents a thermal conductivity (W/(m·K)), A represents a thermal diffusivity (m²/sec), B represents a bulk density (kg/m³), and C represents a specific heat capacity (J/(kg·K)). The thermal diffusivity A was measured using a sample, which was obtained by processing the boron nitride sintered body into a size of length × width × thickness = 10 mm × 10 mm × 0.40 mm, by a laser flash method. As a measurement apparatus, a xenon flash analyzer (manufactured by NETZSCH-Gerätebau GmbH, trade name: LFA447 NanoFlash) was used. The bulk density B was calculated from the volume and mass of the boron nitride sintered body. Results of the thermal conductivity H and the bulk density B are shown in Table 1.

<Measurement of average pore diameter>

The pore volume distribution of the obtained boron nitride sintered body was measured using a mercury porosimeter (device name: AutoPore IV 9500) manufactured by SHIMADZU CORPORATION while increasing a pressure from 0.0042 MPa to 206.8 MPa. In the cumulative pore volume distribution, a pore diameter at which the cumulative pore volume reaches 50% of the total pore volume was regarded as the "average pore diameter". Results are shown in Table 1.

<Measurement of porosity>

The porosity was determined by Calculation Formula (4) below from the bulk density B calculated as described above and the theoretical density (2280 kg/m³) of boron nitride. Results are shown in Table 1.

$$\text{Porosity (\% by volume)} = [1 - (B/2280)] \times 100 \qquad (4)$$

<Measurement of orientation index>

The orientation index [I(002)/I(100)] of the boron nitride sintered body was determined using an X-ray diffractometer (manufactured by Rigaku Corporation, trade name: ULTIMA-IV). A measurement sample (boron nitride sintered body) set on a sample holder of the X-ray diffractometer was irradiated with X rays to perform baseline correction. Thereafter, the peak intensity ratio of (002) plane to (100) plane of boron nitride was calculated. This peak intensity ratio was regarded as the orientation index [I(002)/I(100)]. Results were as shown in Table 1.

<Production of composite body>

The boron nitride sintered body was impregnated with a resin composition containing an epoxy resin (manufactured by Mitsubishi Chemical Corporation, trade name: Epikote 807) and a curing agent (manufactured by Nippon Synthetic Chemical Industry Co., Ltd., trade name: Akumex H-84B) by sequentially performing a depressurized condition and a pressurized condition. The depressurized condition was set at 500 Pa for 30 minutes, and the pressurized condition was set at 1 MPa for 30 minutes. After the impregnating, the resin was cured by heating at the atmospheric pressure and at a temperature of 120°C for 120 minutes to obtain a composite body. This composite body had the thickness (60 mm) that was equal to that of the boron nitride sintered body.

<Content of resin>

The content of the resin in the composite body was as shown in Table 2. The content (% by mass) of this resin is a mass ratio of the resin to the entire composite body. The content of the resin was calculated by calculating the mass of the resin from a difference in mass of the boron nitride sintered body and the composite body and dividing this mass of the resin by the mass of the composite body.

<Evaluation of electrical insulation properties>

The dielectric breakdown voltage was measured using a sample which was obtained by processing the obtained composite body into a size of length × width × thickness = 20 mm × 20 mm × 0.40 mm. The "dielectric breakdown voltage" in the present specification means a value as measured by a withstand voltage tester (manufactured by KIKUSUI ELECTRONICS CORPORATION, device name: TOS-8700) according to JIS C2110-1:2016. A case where the measured value was 20 kV/mm or more was evaluated as "A", a case where the measured value was 10 to 20 kV/mm or more was evaluated as "B", and a case where the measured value was 10 kV/mm or less was evaluated as "C". Results thereof were shown in Table 2.

(Example 2)

10.7 parts by mass of an amorphous boron nitride powder having an oxygen content of 1.7% by mass and an average particle diameter of 3.4 μm, 7.1 parts by mass of a hexagonal boron nitride powder having an oxygen content of 0.1% by mass and an average particle diameter of 16.0 μm, 0.9 parts by mass of calcium carbonate (manufactured by Shiraishi Kogyo Kaisha, Ltd., trade name: PC-700), and 1.6 parts by mass of boric acid were mixed using a Henschel mixer to obtain a mixture. Thereafter, 380 parts by mass of water was added with respect to 100 parts by mass of the mixture and pulverized with a ball mill for 5 hours to obtain an aqueous slurry. Polyvinyl alcohol (manufactured by Nippon Synthetic Chemical Industry Co., Ltd., trade name: GOHSENOL) was added to this aqueous slurry so that the concentration thereof was 3.0% by mass, and the resultant mixture was heated and stirred at 50°C until dissolved. Thereafter, the aqueous slurry was subjected to a spheroidizing treatment at a drying temperature of 200°C in a spray dryer to obtain a granulated substance. As a spheroidizing device of the spray dryer, a rotary atomizer was used.

87 g of the granulated substance obtained by the spheroidizing treatment was pressurized using a powder pressing machine at 40 MPa for 30 seconds to obtain a molded body having a block shape (length × width × thickness = 49 mm × 25 mm × 57 mm). The molded body was put in a boron nitride container and introduced into a batch-type high-frequency furnace. In the batch-type high-frequency furnace, heating was performed for 10 hours under the conditions of normal pressure, a nitrogen flow rate of 5 L/min, and 2050°C. Thereafter, a boron nitride sintered body was extracted from the boron nitride container. In this way, a block-shaped boron nitride sintered body was obtained. The thickness t of the boron nitride sintered body was 60 mm.

Each evaluation of the boron nitride sintered body obtained in this way was performed in the same manner as in Example 1. Furthermore, a composite body was produced in the same manner as in Example 1, using this boron nitride sintered body. The thickness of the composite body was 60 mm. Further, the dielectric breakdown voltage of the composite body was measured in the same manner as in Example 1. Measurement results were as shown in Table 1 and Table 2.

(Example 3)

A boron nitride sintered body (thickness: 10 mm) and a composite body (thickness: 10 mm) were produced in the same manner as in Example 1, except that the amount of the blend used when a molded body was produced was set to 16.2 g and the thickness of the molded body was set to 9.5 mm.

Each measurement of the boron nitride sintered body and the composite body obtained in this way was performed in the same manner as in Example 1. Measurement results were as shown in Table 1 and Table 2.

(Example 4)

A boron nitride sintered body (thickness: 2.0 mm) and a composite body (thickness: 2.0 mm) were produced in the same manner as in Example 1, except that the amount of the blend used when a molded body was produced was set to 3.2 g, the thickness of the molded body was set to 1.9 mm, and the boron nitride sintered body was impregnated with the resin composition at the atmospheric pressure using a bar coater when a composite body was produced.

Each measurement of the boron nitride sintered body and the composite body obtained in this way was performed in the same manner as in Example 1. Measurement results were as shown in Table 1 and Table 2.

(Example 5)

A sintered body (thickness: 1.0 mm) and a composite body (thickness: 1.0 mm) were produced in the same manner as in Example 1, except that the amount of the blend used when a molded body was produced was set to 1.6 g, the thickness of the molded body was set to 0.95 mm, and the boron nitride sintered body was impregnated with the resin composition at the atmospheric pressure using a bar coater when a composite body was produced.

Each measurement of the boron nitride sintered body and the composite body obtained in this way was performed in the same manner as in Example 1. Measurement results were as shown in Table 1 and Table 2.

(Example 6)

A boron nitride sintered body (thickness: 0.1 mm) and a composite body (thickness: 0.1 mm) were produced in the same manner as in Example 1, except that the amount of the blend used when a molded body was produced was set to 0.16 g, the thickness of the molded body was set to 0.09 mm, and the boron nitride sintered body was impregnated with the resin composition at the atmospheric pressure using a bar coater when a composite body was produced.

Each measurement of the boron nitride sintered body and the composite body obtained in this way was performed in the same manner as in Example 1. Measurement results were as shown in Table 1 and Table 2.

(Example 7)

A boron nitride sintered body (thickness: 0.1 mm) and a composite body (thickness: 0.1 mm) were produced in the same manner as in Example 2, except that the amount of the granulated substance used when a molded body was produced was set to 0.15 g, the thickness of the molded body was set to 0.09 mm, and the boron nitride sintered body was impregnated with the resin composition at the atmospheric pressure using a bar coater when a composite body was produced.

Each measurement of the boron nitride sintered body and the composite body obtained in this way was performed in the same manner as in Example 1. Measurement results were as shown in Table 1 and Table 2.

(Comparative Example 1)

[Production of boron nitride sintered body]

40.0% by mass of an amorphous boron nitride powder (manufactured by Denka Company Limited, oxygen content: 1.5%, boron nitride purity: 97.6%, average particle diameter: 6.0 $\mu$m) and 60.0% by mass of a hexagonal boron nitride powder (manufactured by Denka Company Limited, oxygen content: 0.3%, boron nitride purity: 99.0%, average particle diameter: 30.0 $\mu$m) were weighed in a container. 14 parts by mass of a sintering aid (boric acid, calcium carbonate) was added with respect to 100 parts by mass of the total of two powders described above, an organic binder and water were then added and mixed, followed by drying granulation to prepare a mixed powder of nitride.

The mixed powder was filled in a cold isostatic pressing (CIP) apparatus (manufactured by Kobe Steel, Ltd., trade name: ADW800) and the mixed powder was compressed by applying a pressure of 60 MPa to obtain a molded body. The obtained molded body was sintered using a batch-type high-frequency furnace (manufactured by Fuji Dempa Kogyo Co., Ltd., trade name: FTH-300-1H) while being held at 2000°C for 10 hours, thereby preparing a boron nitride sintered body. Note that, firing was performed by adjusting the inside of the furnace in a nitrogen atmosphere while nitrogen was allowed to flow inside the furnace in a standard state at a flow rate of 10 L/min. The obtained boron nitride sintered body had an average pore diameter of 2.5 $\mu$m, a porosity of 58% by volume, an orientation index of 7, a bulk density of 1020 kg/m$^3$, and a thermal conductivity of 34 W/(m·K).

The boron nitride sintered body prepared as described above was impregnated with the same thermosetting resin composition as that of Example 1 by the following method. First, the nitride sintered body and the thermosetting resin composition, which had been put in the container, were put in a vacuum heating impregnating apparatus (manufactured by KYOSIN ENGINEERING CORPORATION, trade name: G-555 AT-R). Next, the inside of the apparatus was degassed for 10 minutes under the conditions of a temperature of 100°C and a pressure of 15 Pa. After the degassing, while the same conditions were maintained, the nitride sintered body was immersed in the thermosetting resin composition for 40 minutes to impregnate the nitride sintered body with the thermosetting composition.

Thereafter, the nitride sintered body and the container in which the thermosetting resin composition was put were extracted and put in a heating-pressurizing impregnating apparatus (manufactured by KYOSIN ENGINEERING CORPORATION, trade name: HP-4030AA-H45), and the apparatus was maintained for 120 minutes under the conditions of a temperature of 130°C and a pressure of 3.5 MPa, thereby further impregnating the nitride sintered body with the thermosetting resin composition. Thereafter, the nitride sintered body was extracted from the apparatus, and the thermosetting resin composition was semi-cured by heating for 8 hours under the conditions of a temperature of 120°C and the atmospheric pressure, thereby preparing a boron nitride sintered body filled with the resin (resin-impregnated body). The content of the semi-cured product in the obtained resin-impregnated body was 50% by volume. The size of the resin-impregnated body of the composite body thus obtained was a vertical size (length): 50 mm, a horizontal size (width): 50 mm, and a height (thickness): 50 mm.

Each measurement of the boron nitride sintered body and the composite body obtained in this way was performed in the same manner as in Example 1. Measurement results were as shown in Table 1 and Table 2.

[Table 1]

| | Boron nitride sintered body | | | | | |
|---|---|---|---|---|---|---|
| | Thickness [mm] | Porosity [% by volume] | Average pore diameter [$\mu$m] | Orientation index | Bulk density [kg/m$^3$] | Thermal conductivity [w/(m·K)] |
| Example 1 | 60 | 58 | 0.9 | 15 | 950 | 40 |
| Example 2 | 60 | 49 | 2.5 | 12 | 1120 | 38 |
| Example 3 | 10 | 62 | 1.1 | 12 | 850 | 38 |
| Example 4 | 2 | 54 | 0.8 | 16 | 1040 | 46 |
| Example 5 | 1 | 56 | 0.9 | 11 | 1000 | 42 |
| Example 6 | 0.1 | 51 | 0.7 | 10 | 1100 | 37 |
| Example 7 | 0.1 | 52 | 2.4 | 12 | 1080 | 49 |
| Comparative Example 1 | 50 | 58 | 2.5 | 7 | 1020 | 34 |

[Table 2]

| | Composite body | |
|---|---|---|
| | Content of resin [% by mass] | Evaluation of electrical insulation properties |
| Example 1 | 41 | A |
| Example 2 | 35 | B |
| Example 3 | 46 | A |
| Example 4 | 38 | A |
| Example 5 | 40 | A |
| Example 6 | 35 | A |
| Example 7 | 36 | B |
| Comparative Example 1 | 40 | C |

**Industrial Applicability**

According to the present disclosure, there are provided a boron nitride sintered body and a composite body which are thin and suitable as a member of an electronic component and the like, and manufacturing methods therefor. Furthermore, a heat dissipation member which is suitable as a member of an electronic component and the like is provided.

**Reference Signs List**

10: composite body, 20: boron nitride sintered body.

**Claims**

1.   A method for manufacturing a composite body, the method comprising:

a sintering step of molding and heating a blend containing a boron carbonitride powder and a sintering aid to obtain a boron nitride sintered body including boron nitride particles and pores; and
an impregnating step of impregnating the boron nitride sintered body with a resin composition, the composite body having the boron nitride sintered body and a resin filled in at least some of the pores of the boron nitride sintered body.

2. A method for manufacturing a composite body according to claim 1, the method further comprising a nitriding step of firing a boron carbide powder in a nitrogen atmosphere to obtain a fired product containing boron carbonitride, the fired product is used instead of the boron carbonitride powder in the sintering step.

3. The method for manufacturing a composite body according to claim 1 or 2, wherein a porosity of the boron nitride sintered body obtained in the sintering step is 30 to 65% by volume.

4. The method for manufacturing a composite body according to any one of claims 1 to 3, wherein the boron nitride sintered body obtained in the sintering step has a thickness of 2 mm or more, and
the method includes a cutting step of cutting the boron nitride sintered body to obtain the boron nitride sintered body having a sheet shape with a thickness of less than 2 mm, between the sintering step and the impregnating step.

5. The method for manufacturing a composite body according to any one of claims 1 to 3, wherein a thickness of the boron nitride sintered body obtained in the sintering step is less than 2 mm, and
in the impregnating step, the boron nitride sintered body obtained in the sintering step is impregnated with the resin composition without cutting the boron nitride sintered body.

6. The method for manufacturing a composite body according to any one of claims 1 to 5, comprising a curing step of curing the resin filled in the pores of the boron nitride sintered body after the impregnating step.

**Patentansprüche**

1. Verfahren zum Herstellen eines Verbundkörpers, wobei das Verfahren Folgendes umfasst:

   einen Sinterschritt zum Formen und Erhitzen einer Mischung, die ein Borcarbonitridpulver und ein Sinterhilfsmittel enthält, um einen Bornitrid-Sinterkörper zu erhalten, einschließlich Bornitridpartikel und Poren; und
   einen Imprägnierschritt zum Imprägnieren des Bornitrid-Sinterkörpers mit einer Harzzusammensetzung, wobei der Verbundkörper den Bornitrid-Sinterkörper und ein Harz aufweist, das in mindestens einige der Poren des Bornitrid-Sinterkörpers gefüllt ist.

2. Verfahren zum Herstellen eines Verbundkörpers nach Anspruch 1, wobei das Verfahren weiter einen Nitrierschritt zum Brennen eines Borcarbidpulvers in einer Stickstoffatmosphäre umfasst, um ein gebranntes Produkt zu erhalten, das Borcarbonitrid enthält, wobei das gebrannte Produkt anstelle des Borcarbonitridpulvers im Sinterschritt verwendet wird.

3. Verfahren zum Herstellen eines Verbundkörpers nach Anspruch 1 oder 2, wobei eine Porosität des im Sinterschritt erhaltenen Bornitrid-Sinterkörpers 30 bis 65 Vol.-% beträgt.

4. Verfahren zum Herstellen eines Verbundkörpers nach einem der Ansprüche 1 bis 3, wobei der im Sinterschritt erhaltene Bornitrid-Sinterkörper eine Dicke von 2 mm oder mehr aufweist, und
das Verfahren einen Schneideschritt zum Schneiden des Bornitrid-Sinterkörpers einschließt, um den Bornitrid-Sinterkörper mit einer Blattform mit einer Dicke von weniger als 2 mm zwischen dem Sinterschritt und dem Imprägnierschritt zu erhalten.

5. Verfahren zum Herstellen eines Verbundkörpers nach einem der Ansprüche 1 bis 3, wobei eine Dicke des im Sinterschritt erhaltenen Bornitrid-Sinterkörpers weniger als 2 mm beträgt, und
im Imprägniersschritt der im Sinterschritt erhaltene Bornitrid-Sinterkörper mit der Harzzusammensetzung imprägniert wird, ohne den Bornitrid-Sinterkörper zu schneiden.

6. Verfahren zum Herstellen eines Verbundkörpers nach einem der Ansprüche 1 bis 5, umfassend einen Härtungsschritt zum Härten des in die Poren des Bornitrid-Sinterkörpers gefüllten Harzes nach dem Imprägnierschritt.

**Revendications**

1. Procédé de fabrication d'un corps composite, le procédé comprenant :

   une étape de frittage consistant à mouler et à chauffer un mélange contenant une poudre de carbonitrure de bore et un auxiliaire de frittage pour obtenir un corps fritté en nitrure de bore incluant des particules de nitrure de bore et des pores ; et
   une étape d'imprégnation consistant à imprégner le corps fritté en nitrure de bore avec une composition de résine, le corps composite ayant le corps fritté en nitrure de bore et une résine remplissant au moins certains des pores du corps fritté en nitrure de bore.

2. Procédé de fabrication d'un corps composite selon la revendication 1, le procédé comprenant en outre une étape de nitruration consistant à cuire une poudre de carbure de bore dans une atmosphère d'azote pour obtenir un produit cuit contenant du carbonitrure de bore, le produit cuit est utilisé à la place de la poudre de carbonitrure de bore dans l'étape de frittage.

3. Procédé de fabrication d'un corps composite selon la revendication 1 ou la revendication 2, dans lequel une porosité du corps fritté en nitrure de bore obtenu dans l'étape de frittage est de 30 à 65 % en volume.

4. Procédé de fabrication d'un corps composite selon l'une quelconque des revendications 1 à 3, dans lequel le corps fritté en nitrure de bore obtenu dans l'étape de frittage a une épaisseur de 2 mm ou plus, et
   le procédé inclut une étape de découpe consistant à couper le corps fritté en nitrure de bore pour obtenir le corps fritté en nitrure de bore ayant une forme de feuille d'une épaisseur inférieure à 2 mm, entre l'étape de frittage et l'étape d'imprégnation.

5. Procédé de fabrication d'un corps composite selon l'une quelconque des revendications 1 à 3, dans lequel une épaisseur du corps fritté en nitrure de bore obtenu dans l'étape de frittage est inférieure à 2 mm, et
   dans l'étape d'imprégnation, le corps fritté en nitrure de bore obtenu dans l'étape de frittage est imprégné avec la composition de résine sans couper le corps fritté en nitrure de bore.

6. Procédé de fabrication d'un corps composite selon l'une quelconque des revendications 1 à 5, comprenant une étape de durcissement consistant à durcir la résine remplissant les pores du corps fritté en nitrure de bore après l'étape d'imprégnation.

**Fig.1**

**EP 4 112 588 B1**

**REFERENCES CITED IN THE DESCRIPTION**

**Patent documents cited in the description**

- JP 2014162697 A
- JP 2019073409 A
- WO 2020004600 A1
- WO 2019073690 A1
- WO 2018066277 A1
- JP H05159624 A